# EUROPEAN PATENT APPLICATION

(11) **EP 4 675 683 A1**
(43) Date of publication of application: **07.01.2026**
(21) Application number: 25186584.6
(22) Date of filing: 01.07.2025
(51) Int. Cl.: H01L 23/522, H01L 23/532, H01L 21/768, H01L 23/528

(54) **INTEGRATED CIRCUIT DEVICES INCLUDING INTERCONNECTION STRUCTURE AND METHODS OF FORMING THE SAME**

(30) Priority: 03.07.2024 US 202463667593 P; 03.02.2025 US 202519044060
(71) Applicant: Samsung Electronics Co., Ltd., Suwon-si, Gyeonggi-do 16677 (KR)
(72) Inventor: KIM, Johnsoo, San Jose, CA, 95134 (US); OH, Joongsuk, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

According to some embodiments of the inventive concepts, an integrated circuit device may be provided. The integrated circuit device may include a lower conductive line, a conductive via on the lower conductive line and a stopping pattern between the lower conductive line and the conductive via. A side surface of the stopping pattern may be aligned with the side surface of the lower conductive line and the side surface of the conductive via.

## Description

### BACKGROUND OF THE INVENTION

The present disclosure generally relates to the field of electronics and, more particularly, to integrated circuit devices.

Various interconnection structures, such as back end of line (BEOL) structures, of an integrated circuit device with different configurations and materials have been suggested to reduce resistance thereof so as to improve the performance (e.g., the operation speed) of the integrated circuit device. An interconnection structure comprising conductive patterns that includes metal, such as ruthenium (Ru), has been considered to reduce the resistance thereof, as fine patterning for the conductive patterns of the interconnection structure is needed to achieve higher performance, less power consumption, and multi-functionality of the integrated circuit device. Top-via module process is one of the interconnection structure patterning schemes used for patterning conductive lines (e.g., metal lines) and/or the conductive vias (e.g., metal vias) of the conductive patterns in the interconnection structure when the conductive lines and/or the conductive vias comprise a patternable material (e.g., etchable material without damascene process) such as Ru. The top-via module process may form conductive patterns and recess some of the conductive patterns (e.g., remove upper portions of some of the conductive patterns) to form the (lower) conductive lines and conductive vias thereon. For example, the un-recessed conductive patterns may include the (lower) conductive lines and the conductive vias thereon, and the recessed conductive patterns may only include the (lower) conductive lines. Although the top-via module process may be simpler and more cost-effective than the damascene process, using chemical-mechanical planarization (CMP) process, the shapes, profiles, and heights of the (lower) conductive lines formed by the top-via module process may include undesirable variations depending on the resolution, the shape, and/or the density of the conductive patterns because the top-via module process uses etching process(es), not CMP process. For example, in the top-via module process, spacers (e.g., oxide spacers) on (sidewalls of) the conductive patterns may have various heights and profiles, causing non-uniform heights and/or non-uniform profiles of the conductive lines after the conductive pattern recess process for removing the upper portions of some of the conductive patterns. These non-uniform (lower) conductive lines may cause unintended variation and/or deterioration in the resistance of the interconnection structure and the performance of the integrated circuit device.

### SUMMARY OF THE INVENTION

According to some embodiments, integrated circuit devices may include a lower conductive line, a conductive via on the lower conductive line, and a stopping pattern between the lower conductive line and the conductive via. The side surface of the conductive via may be aligned with a side surface of the lower conductive line. A width of the conductive via in a direction may be equal to a width of the lower conductive line in the direction. A side surface of the stopping pattern may be aligned with the side surface of the lower conductive line and the side surface of the conductive via. A width of the stopping pattern in a direction may be equal to a width of the conductive via in the direction, and the width of the stopping pattern may be equal to a width of the lower conductive line in the direction. The stopping pattern may have an etch selectivity with the conductive via. The stopping pattern may have an etch selectivity with (with respect to) the lower conductive line. The conductive via may include a first material that is etchable, the lower conductive line may include the first material, and the stopping pattern may include a second material that is different from the first material. The first material may be ruthenium (Ru).

According to some embodiments, an integrated circuit device may include an interconnection structure that includes a metal line, a metal via on the metal line, and a stopping pattern between the metal line and the metal via. Side surfaces of the metal line, the metal via, and the stopping pattern are substantially coplanar. The interconnection structure may have a uniform width. The stopping pattern may be in direct contact with the metal line and the metal via. The stopping pattern may have an etch selectivity with the metal via and with the metal line. The metal via and the metal line may include a same metal. The same metal may be ruthenium (Ru).

According to some embodiments, a method of forming an integrated circuit device may include forming a first conductive layer on a substrate, forming a stopping layer on the first conductive layer, forming a second conductive layer on the stopping layer, and patterning the first conductive layer, the stopping layer, and the second conductive layer to form conductive lines, stopping patterns, and conductive vias, respectively. The method of forming the integrated circuit device may further include removing at least one of the conductive vias and removing at least one of the stopping patterns. The at least one of the conductive vias and the at least one of the stopping patterns may overlap each other, respectively in a direction that is perpendicular to an upper surface of the substrate. The patterning the first conductive layer, the stopping layer, and the second conductive layer may include etching the first conductive layer, the stopping layer, and the second conductive layer by a same etching process or a same series of etching processes. Each of the first conductive layer and the second conductive layer may include a first material, and the stopping layer may include a second material that is different from the first material. The first material may be ruthenium (Ru).

### BRIEF DESCRIPTION OF THE DRAWINGS

FIGS. 1A and 1B are cross-sectional views of an interconnection structure of an integrated circuit device according to some embodiments.
FIG. 2 is a flow chart of a method of forming an interconnection structure of an integrated circuit device according to some embodiments.
FIGS. 3 through 10 are cross-sectional views illustrating a method of forming an interconnection structure of an integrated circuit device according to some embodiments.

### DETAILED DESCRIPTION

Metal(s) (e.g., ruthenium (Ru), cobalt (Co), molybdenum (Mo), tungsten (W), and/or aluminum (Al)) may be used to form conductive patterns (including conductive vias and/or conductive lines) in an interconnection structure (e.g., a BEOL structure) to reduce resistance thereof. The interconnection structure may be formed by a top-via module process when the conductive patterns of the interconnection structure comprise a patternable (e.g., etchable) metal, such as Ru, Co, Mo, W, Rh, and Al. The top-via module process may include forming conductive patterns and recessing some of the conductive patterns (e.g., removing upper portions of some of the conductive patterns) to form the (lower) conductive lines and conductive vias thereon. For example, the un-recessed conductive patterns may include the (lower) conductive lines and the conductive vias thereon, and the recessed conductive patterns may only include the (lower) conductive lines. For example, lower portions of the conductive patterns may be referred to as the (lower) conductive lines, and upper portions of the conductive patterns may be referred to as the conductive vias. To achieve uniform shapes, profiles, and heights of the (lower) conductive lines, a stopping pattern may be formed in the conductive pattern (e.g., between the conductive via and the (corresponding) conductive line) so that the performance of the integrated circuit device is improved (e.g., the performance variability is reduced).

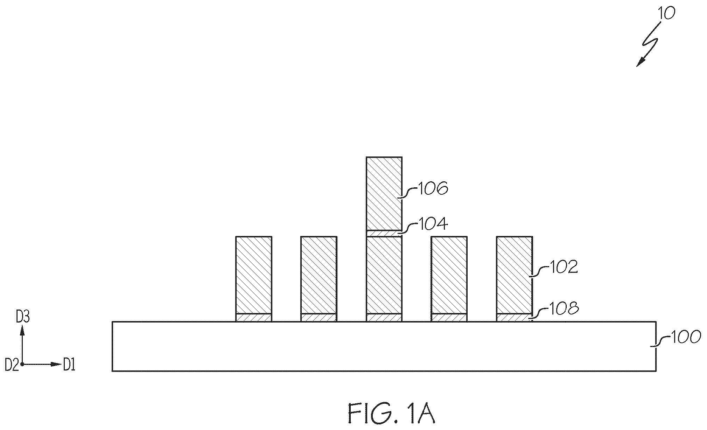

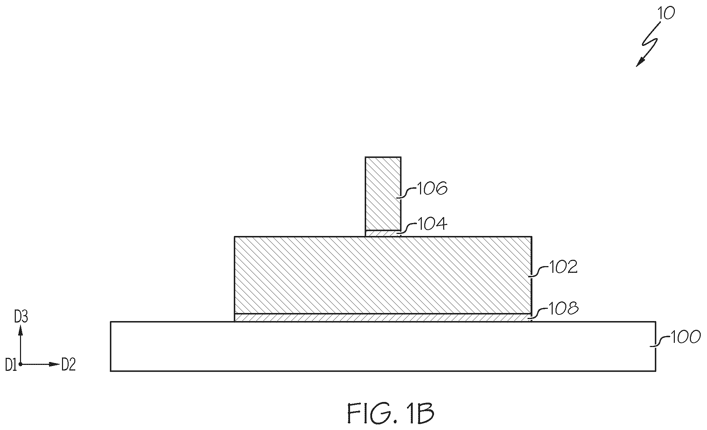

FIGS. 1A and 1B are cross-sectional views of an interconnection structure of an integrated circuit device 10 according to some embodiments. The integrated circuit device 10 may include a substrate 100. Herein, the substrate 100 is not limited to the lowermost layer of the integrated circuit device 10. For example, the substrate 100 may be a front-end-of-line (FEOL) structure, a middle-end-of-line (MEOL) structure, or a BEOL structure (e.g., a lower portion of a BEOL structure). The interconnection structure may be on the substrate 100. The interconnection structure may include a conductive line 102, a stopping pattern 104, and a conductive via 106. In some embodiments, the conductive via 106 is on the conductive line 102. The stopping pattern 104 may be between the conductive line 102 and the conductive via 106 (in a vertical direction that is perpendicular to an upper surface of the substrate 100). In some embodiments, the integrated circuit device 10 may further include an intermediate conductive pattern 108 between the interconnection structure (the conductive line 102) and the substrate 100 (in the vertical direction). In some embodiments, the intermediate conductive pattern 108 may be omitted. The first direction D1 and the second direction D2 may be parallel with an upper surface of the substrate 100. The first direction D1 and the second direction D2 may intersect each other. The first direction D1 and the second direction D2 may be perpendicular to each other. The third direction D3 may be perpendicular to the upper surface of the substrate 100.

The conductive line 102 and the conductive via 106 may include a same (etchable) material (e.g., a same metal). In some embodiments, the conductive line 102 and the conductive via 106 may be formed of a same (etchable) metal. For example, the conductive line 102 and the conductive via 106 may include Ru, but the embodiments are not limited thereto. In some embodiments, the stopping pattern 104 may have an etch selectivity with the conductive line 102 and/or the conductive via 106. In some embodiments, the stopping pattern 104 may include a material (e.g., a conductive material) different from the material in the conductive line 102 and the conductive via 106. For example, the stopping pattern 104 may include tantalum nitride (TaN), tungsten carbon nitride (WCN),tungsten nitride (WN), and/or titanium nitride (TiN), but the embodiments are not limited thereto. In some embodiments, the intermediate conductive pattern 108 may include TaN, WCN, WN, and/or TiN, but the embodiments are not limited thereto.

A side surface of the conductive line 102 and a side surface of the conductive via 106 may be aligned in the vertical direction. In some embodiments, a side surface of the stopping pattern 104 may be aligned with the side surface of the conductive line 102 and/or the side surface of the conductive via 106 (in the vertical direction). For example, a side surface of the interconnection structure may be an entirely straight line (in the vertical direction). A side surface of the conductive line 102, the side surface of the corresponding conductive via 106, and the side surface of the corresponding stopping pattern 104 may be (substantially) coplanar.

A width of the conductive line 102 (in a horizontal direction that is parallel with the upper surface of the substrate 100) may be equal to a width of the conductive via 106 (in the horizontal direction). In some embodiments, a width of the stopping pattern 104 may be equal to the width of the conductive line 102 and/or equal to the width of the conductive via 106 (in the horizontal direction). For example, the interconnection structure may have a uniform width (in the horizontal direction).

In some embodiments, the integrated circuit device 10 may include a plurality of interconnection structures. For example, the interconnection structures may be spaced apart from each other in the horizontal direction. The interconnection structures may include a plurality of conductive lines 102. A conductive via 106 may be on ones of the plurality of conductive lines 102. For example, the conductive via 106 may overlap the corresponding one of the plurality of conductive lines 102 (in the vertical direction). A stopping pattern 104 may be between the conductive via 106 and the corresponding one of the plurality of conductive lines 102 (in the vertical direction). In some embodiments, the interconnection structure may include a plurality of conductive vias 106. The conductive vias 106 may be positioned on the corresponding conductive lines 102, respectively. The number of the conductive vias 106 may be equal to or less than the number of the conductive lines 102. For example, some of the conductive lines 102 may be free of the stopping pattern 104 thereon. The interconnection structure may include a plurality of stopping patterns 104 between the conductive vias 106 and the corresponding conductive lines 102, respectively. For example, a conductive line 102 that has no conductive via 106 thereon may not have a stopping pattern 104 thereon. For example, a conductive line 102 that does not overlap the conductive via 106 in the vertical direction may not overlap the stopping pattern 104 in the vertical direction. In some embodiments, a conductive line 102 may have a stopping pattern 104 thereon only when the conductive line 102 has a conductive via 106 thereon. The conductive via 106 may be (electrically) connected to the (corresponding) conductive line 102 through the stopping pattern 104 therebetween. In some embodiments, the stopping pattern 104 may be in (direct) contact with the conductive via 106 and the (corresponding) conductive line 102. In some embodiments, the integrated circuit device 10 may further include a plurality of intermediate conductive patterns 108. For example, each of the intermediate conductive patterns 108 may be between a corresponding conductive line 102 and the substrate 100 (in the vertical direction). The plurality of intermediate conductive patterns 108 may be spaced apart from each other in the horizontal direction.

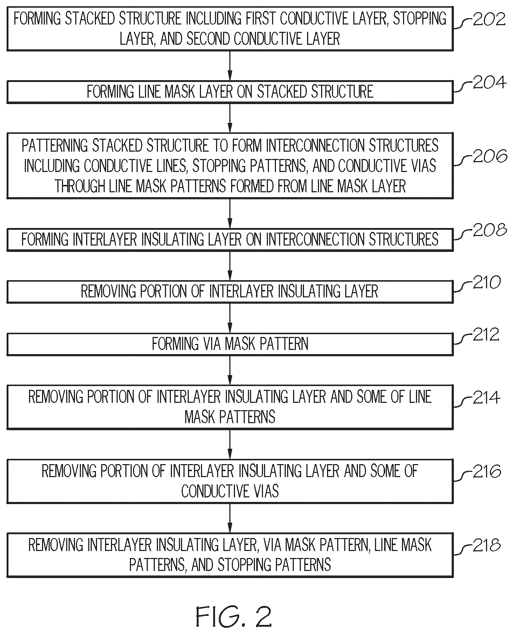

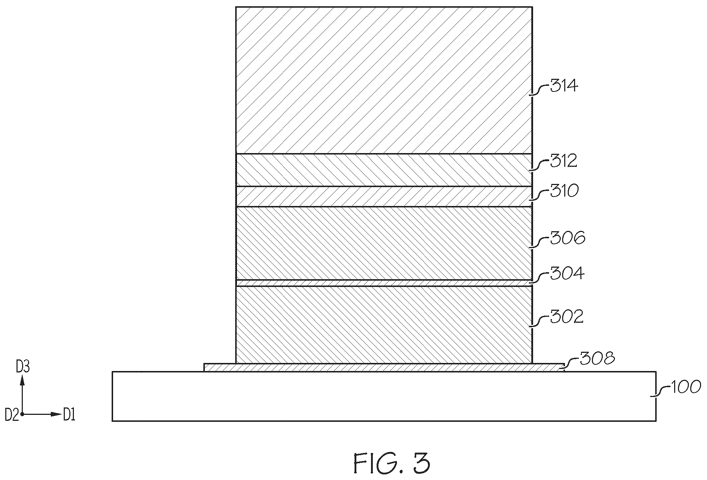

FIG. 2 is a flow chart of a method of forming an interconnection structure of an integrated circuit device 10 according to some embodiments. FIGS. 3 through 10 are cross-sectional views illustrating a method of forming an interconnection structure of an integrated circuit device 10 according to some embodiments.

Referring to FIG. 3, a substrate 100 may be provided. A stacked structure comprising a first conductive layer 302, a stopping layer 304, and a second conductive layer 306 may be formed on the substrate 100 (Block 202 in FIG. 2). The first conductive layer 302, the stopping layer 304, and the second conductive layer 306 may be sequentially stacked on the substrate 100. For example, the stopping layer 304 may be between the first conductive layer 302 and the second conductive layer 306 in the vertical direction. In some embodiments, an intermediate conductive layer 308 may be formed between the stacked structure and the substrate 100 (in the vertical direction). For example, the intermediate conductive layer 308 may be between the first conductive layer 302 and the substrate 100 in the vertical direction. In some embodiments, the intermediate conductive layer 308 may be omitted. In some embodiments, the first conductive layer 302 and the second conductive layer 306 may include a same material (e.g., a same metal). For example, the first conductive layer 302 and the second conductive layer 306 may include (e.g., may be formed of) Ru, but the embodiments are not limited thereto. The stopping layer 304 may include conductive material (e.g., metal). In some embodiments, the stopping layer 304 may include (e.g., may be formed of) TaN, but the embodiments are not limited thereto. In some embodiments, the intermediate conductive layer may include conductive material, such as metal. The intermediate conductive layer 308 may include TaN, but the embodiments are not limited thereto. The first conductive layer 302, the stopping layer 304, the second conductive layer 306, and the intermediate conductive layer 308 may be formed by, for example, a chemical vapor deposition (CVD), a physical vapor deposition (PVD), an atomic layer deposition (ALD), and/or a combination thereof. The thickness of the stopping layer 304 in the vertical direction may be less than the thickness of the first conductive layer 302 in the vertical direction and/or less than the thickness of the second conductive layer 306 in the vertical direction. In some embodiments, the thickness of the stopping layer 304 in the vertical direction may be (about) 1 to 2 nanometers (nm), but the embodiments are not limited thereto.

A line mask layer may be formed on the stacked structure (Block 204 in FIG. 2). The line mask layer may be formed on an upper surface of the second conductive layer 306. The line mask layer may comprise a single layer or a plurality of sub-layers. In FIG. 3, the line mask layer is illustrated to have three sub-layers 310, 312, and 314, but the embodiments are not limited thereto. The number and the materials of the sub-layers of the line mask layer may vary depending on the patterning conditions, such as resolution, shape, profile, and density of the patterns (e.g., the conductive lines 102, the stopping patterns 104, and the conductive vias 106) to be formed by the line mask layer. In some embodiments, a first sub-layer 310 may include titanium nitride (TiN), a second sub-layer 312 may include amorphous silicon, and a third sub-layer 314 may include silicon nitride (SiN), but the embodiments are not limited thereto.

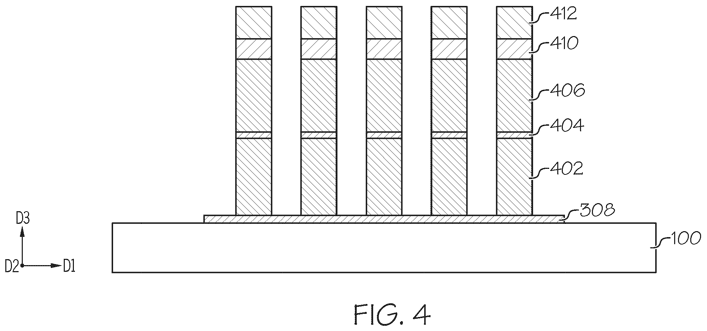

Referring to FIG. 4, the stacked structure may be patterned to form the interconnection structures that include conductive lines 402, stopping patterns 404, and conductive vias 406 through line mask patterns (e.g., 410 and 412) formed (patterned) from the line mask layer (Block 206 in FIG. 2). The conductive lines 402, the stopping patterns 404, and the conductive vias 406 in FIG. 4 may correspond to the conductive lines 102, the stopping patterns 104, and the conductive vias 106 in FIGS. 1A and 1B, respectively. In FIG. 4, a first sub-pattern 410 patterned from the first sub-layer 310 and a second sub-pattern 412 patterned from the second sub-layer 312 remain after forming the interconnection structures, but the embodiments are not limited thereto. For example, only the first sub-pattern 410 may remain after forming the interconnection structures. In some embodiments, a third sub-pattern 414 (not illustrated) patterned from the third sub-layer 314 may remain after forming the interconnection structures. In some embodiments, no sub-patterns (410, 412, and 414) may remain after forming the interconnection structures. In FIG. 4, the interconnection structures may be formed by an etch process or a series of etch processes (e.g., dry etch process) using the first sub-pattern 410 and the second sub-pattern 412 as etch mask patterns, but the embodiments are not limited thereto. For example, the number and configuration of the sub-patterns working as etch mask patterns may vary. In some embodiments, the conductive lines 402, the stopping patterns 404, and the conductive vias 406 may be formed by a same etch process (e.g., a dry etch process) or a same series of etch processes (e.g., dry etch processes).

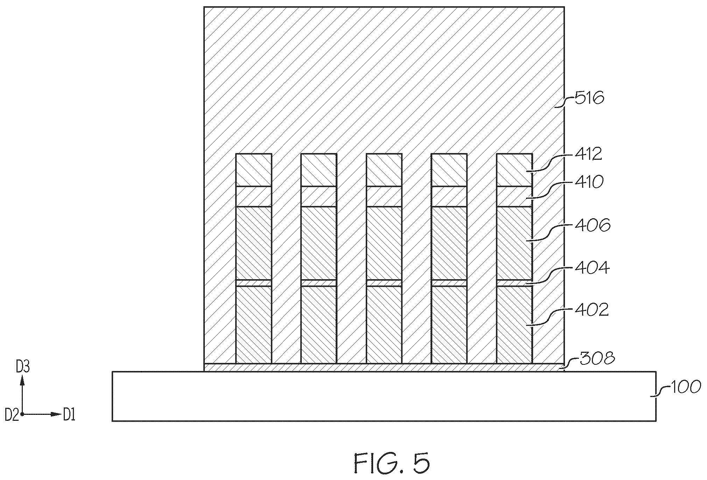

Referring to FIG. 5, an interlayer insulating layer 516 may be formed on the interconnection structures (the conductive lines 402, the stopping patterns 404, and the conductive vias 406) (Block 208 in FIG. 2). The interlayer insulating layer 516 may be formed on the line mask patterns (e.g., the first sub-patterns 410 and the second sub-patterns 412). The interlayer insulating layer 516 may at least partially fill spaces between the interconnection structures and spaces between the line mask patterns. In some embodiments, the interlayer insulating layer 516 may extend around (e.g., surround) the interconnection structures and/or the line mask patterns. For example, the interconnection structures and the line mask patterns may be in the interlayer insulating layer 516. The interlayer insulating layer 516 may include, for example, an oxide material, but the embodiments are not limited thereto.

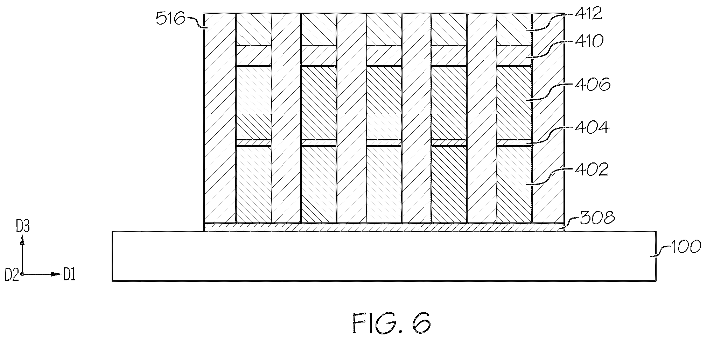

Referring to FIG. 6, a portion of the interlayer insulating layer 516 may be removed (Block 210 in FIG. 2). An upper surface of the interlayer insulating layer 516 may be lowered by, for example, an etch back process and/or a CMP process. In some embodiments, upper surfaces of the line mask patterns may be exposed by removing an upper portion of the interlayer insulating layer 516. For example, upper surfaces of the second sub-patterns 412 may be exposed by removing the upper portion of the interlayer insulating layer 516. The upper surfaces of the line mask patterns (e.g., the upper surface of the second sub-patterns 412) may be coplanar with the upper surface of the interlayer insulating layer 516.

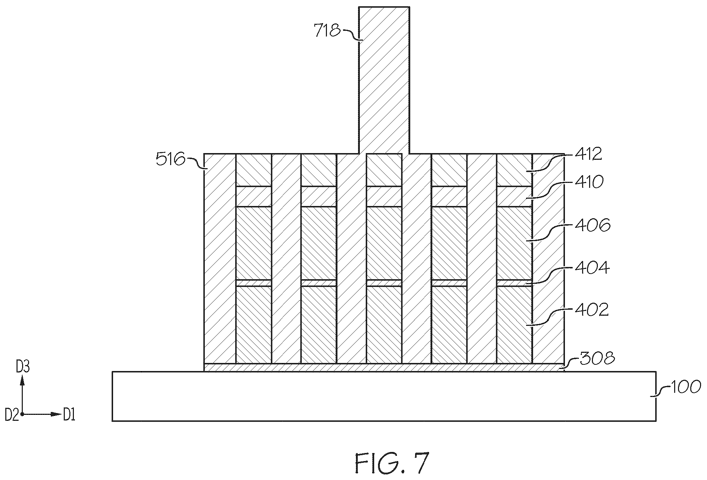

Referring to FIG. 7, a via mask pattern 718 may be formed on the line mask patterns (e.g., the first sub-patterns 410 and the second sub-patterns 412) and/or the interlayer insulating layer 516 (Block 212 in FIG. 2). In some embodiments, the via mask pattern 718 may overlap at least one of the interconnection structures and the line mask patterns thereon in the vertical direction. For example, The via mask pattern 718 may overlap at least one of the conductive lines 402, the corresponding conductive via 406 thereon, and the stopping pattern 404 between the at least one of the conductive lines 402 and the corresponding conductive via 406. in the vertical direction. The via mask pattern 718 may overlap the first sub-pattern 410 and the second sub-pattern 412 on the at least one of the conductive lines 402 in the vertical direction. The via mask pattern 718 may include an oxide material, but the embodiments are not limited thereto. In some embodiments, the via mask pattern 718 and the interlayer insulating layer 516 may include a same material.

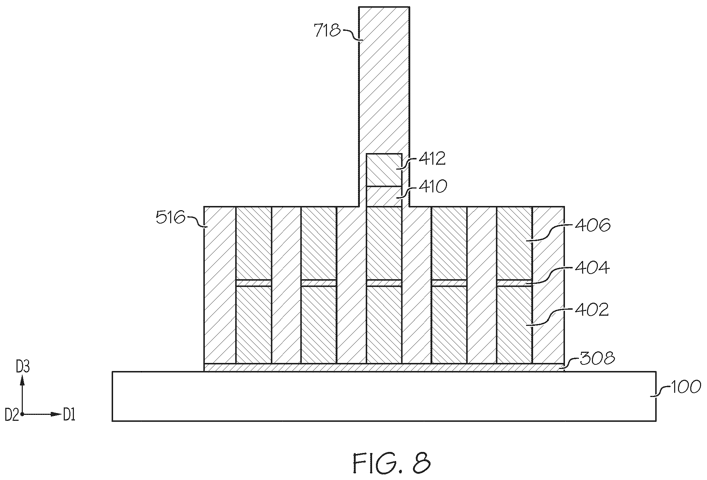

Referring to FIG. 8, the line mask patterns (e.g., the first sub-pattern 410 and the second sub-pattern 412) that do not overlap (e.g., are not covered by) the via mask pattern 718 in the vertical direction may be removed along with a portion of the interlayer insulating layer 516 (Block 214 in FIG. 2). In some embodiments, an upper portion of the interlayer insulating layer 516 may be partially removed (by, for example, dry etch back process). For example, the upper surface of the interlayer insulating layer 516 may be lowered to expose upper surfaces of the interconnection structures. In some embodiments, the upper surfaces of the conductive vias 406 may be exposed except the upper surface of the conductive vias 406 that is overlapped with (e.g., covered by) the via mask pattern 718 in the vertical direction. For example, the upper surface of the interlayer insulating layer 516 may be coplanar with the upper surfaces of the interconnection structures (e.g., the upper surfaces of the conductive vias 406). In some embodiments, an upper portion of the via mask pattern 718 may be partially removed. However, the line mask patterns (e.g., the first sub-pattern 410 and the second sub-pattern 412) and the interconnection structures including the conductive lines 402, the stopping patterns 404, and the conductive vias 406 that overlap the via mask pattern 718 in the vertical direction may not be exposed (may remain to be covered by the via mask pattern 718).

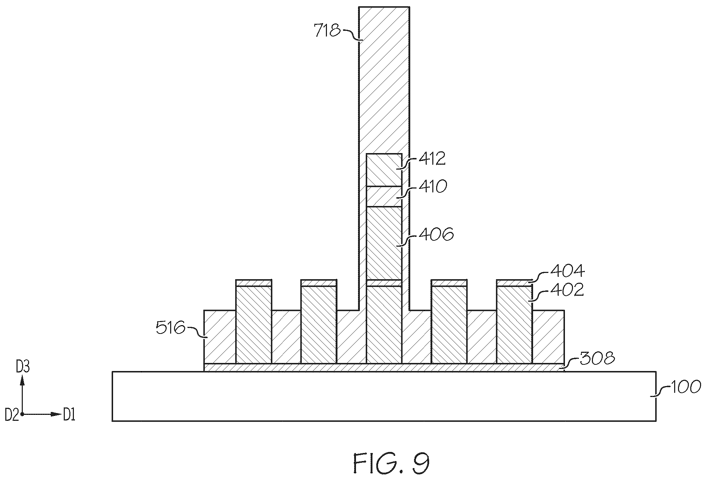

Referring to FIG. 9, the conductive vias 406 that do not overlap (e.g., are not covered by) the via mask pattern 718 in the vertical direction and a portion of the interlayer insulating layer 516 may be removed (Block 216 in FIG. 2). In some embodiments, an upper portion of the interlayer insulating layer 516 may be partially removed (by, for example, dry etch back process). For example, the upper surface of the interlayer insulating layer 516 may be lowered to expose upper surfaces of the stopping patterns 404. In some embodiments, the upper surfaces of the stopping patterns 404 may be exposed except the upper surface of the stopping patterns 404 that is overlapped with (e.g., covered by) the via mask pattern 718 in the vertical direction. For example, the upper surface of the interlayer insulating layer 516 may be lower than the upper surfaces of the stopping patterns 404. For example, the upper surface of the interlayer insulating layer 516 may be closer to the upper surface of the substrate 100 than the upper surfaces of the stopping patterns 404 in the vertical direction. In some embodiments, an upper portion of the via mask pattern 718 may be partially removed. However, the line mask patterns (e.g., the first sub-pattern 410 and the second sub-pattern 412) and the interconnection structures including the conductive lines 402, the stopping patterns 404, and the conductive vias 406 that overlap the via mask pattern 718 in the vertical direction may not be exposed (may remain to be covered by the via mask pattern 718).

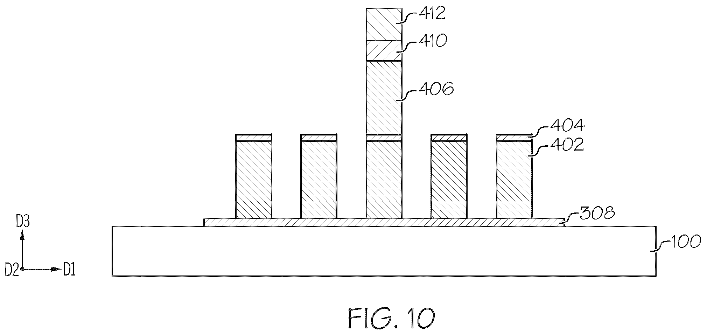

Referring to FIG. 10, the via mask pattern 718 and the interlayer insulating layer 516 may be removed (Block 218 in FIG. 2). The line mask pattern (e.g., the first sub-pattern 410 and the second sub-pattern 412) that was overlapped (e.g., covered) by the via mask pattern 718 in the vertical direction may be exposed. The interconnection structure that was overlapped (e.g., covered) by the via mask pattern 718 in the vertical direction may include a conductive line 402, a conductive via 406 on the conductive line 402, and a stopping pattern 404 between the conductive line 402 and the conductive via 406. The interconnection structure that was overlapped (e.g., covered) by the via mask pattern 718 in the vertical direction may have the line mask pattern thereon. The interconnection structures that were not overlapped (e.g., not covered) by the via mask pattern 718 in the vertical direction may (each) include a stopping pattern 404 and/or a conductive line 402. For example, the conductive via 406 and the line mask pattern (e.g., the first sub-pattern 410 and the second sub-pattern 412) may not remain in/on the interconnection structures that were not overlapped (e.g., not covered) by the via mask pattern 718 in the vertical direction. For example, only the interconnection structure that was overlapped (e.g., covered) by the via mask pattern 718 in the vertical direction may include the conductive via 406 and may have the line mask pattern thereon.

Referring to FIGS. 1A, 1B, and 10, the line mask pattern (e.g., the first sub-pattern 410 and the second sub-pattern 412) and the stopping patterns 404 (the stopping patterns 104) that are not overlapped (e.g., not covered) by the conductive via 406 (the conductive via 106) in the vertical direction may be removed (by, for example, dry etch process). In some embodiments, portions of the intermediate conductive layer 308 may be patterned (according to the interconnection structures) to form the intermediate conductive patterns 108 and expose portions of the upper surface of the substrate 100. For example, the interconnection structures may be (electrically) connected to the substrate 100 through the intermediate conductive patterns 108. In some embodiments, at least one from among a plurality of conductive lines 102 may include a stopping pattern 104 and a conductive via 106 thereon. The stopping pattern 104 may be between the conductive line 102 and the conductive via 106. Other conductive lines 102 from among the plurality of conductive lines 102 may not have the stopping pattern 104 and the conductive via 106 thereon. For example, only the conductive line 102 having the conductive via 106 thereon may have the stopping pattern 104 between the conductive line 102 and the conductive via 106.

Example embodiments are described herein with reference to the accompanying drawings. Many different forms and embodiments are possible without deviating from the scope and teachings of this disclosure and so the disclosure should not be construed as limited to the example embodiments set forth herein. Rather, these example embodiments are provided so that this disclosure will be thorough and complete and will convey the scope of the disclosure to those skilled in the art. In the drawings, the sizes and relative sizes of layers and regions may be exaggerated for clarity. Like reference numbers refer to like elements throughout unless clearly stated otherwise.

Example embodiments of the present inventive concept are described herein with reference to cross-sectional views or plan views that are schematic illustrations of idealized embodiments and intermediate structures of example embodiments. As such, variations from the shapes of the illustrations as a result, for example, of manufacturing techniques and/or tolerances, are to be expected. Thus, example embodiments of the present inventive concept should not be construed as limited to the particular shapes illustrated herein but include deviations in shapes that result, for example, from manufacturing.

Unless otherwise defined, all terms (including technical and scientific terms) used herein have the same meaning as commonly understood by one of ordinary skill in the art to which the present inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the present inventive concept. As used herein, the singular forms "a," "an" and "the" are intended to include the plural forms as well, unless the context clearly indicates otherwise. It will be further understood that the terms "comprises," "comprising," "includes" and/or "including," when used in this specification, specify the presence of the stated features, steps, operations, elements and/or components, but do not preclude the presence or addition of one or more other features, steps, operations, elements, components and/or groups thereof. As used herein the term "and/or" includes any and all combinations of one or more of the associated listed items.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

It should be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present inventive concept.

## Claims

1. An integrated circuit device comprising:
a lower conductive line;
a conductive via on the lower conductive line; and
a stopping pattern between the lower conductive line and the conductive via.

2. The integrated circuit device of Claim 1, wherein a side surface of the conductive via is aligned with a side surface of the lower conductive line.

3. The integrated circuit device of Claim 2, wherein a width of the conductive via in a direction is equal to a width of the lower conductive line in the direction.

4. The integrated circuit device of Claim 2 or 3, wherein a side surface of the stopping pattern is aligned with the side surface of the lower conductive line and the side surface of the conductive via.

5. The integrated circuit device of Claim 4, wherein a width of the stopping pattern in a direction is equal to a width of the conductive via in the direction, and
wherein the width of the stopping pattern is equal to a width of the lower conductive line in the direction.

6. The integrated circuit device of any one of Claims 1 to 5, wherein the stopping pattern has an etch selectivity with the conductive via.

7. The integrated circuit device of Claim 6, wherein the stopping pattern has an etch selectivity with the lower conductive line.

8. The integrated circuit device of Claim 7, wherein the conductive via includes a first material that is etchable,
wherein the lower conductive line includes the first material, and
wherein the stopping pattern includes a second material that is different from the first material.

9. The integrated circuit device of Claim 8, wherein the first material is ruthenium, Ru.

10. The integrated circuit device of any one of Claims 1 to 9, wherein:
the conductive line is a metal line,
the conductive via is a metal via on the metal line, and
side surfaces of the metal line, the metal via, and the stopping pattern are substantially coplanar.

11. The integrated circuit device of Claim 10, wherein the interconnection structure has a uniform width.

12. The integrated circuit device of Claim 10 or 11, wherein the stopping pattern is in direct contact with the metal line and the metal via.

13. The integrated circuit device of Claim 12, wherein the stopping pattern has an etch selectivity with the metal via and with the metal line.

14. The integrated circuit device of Claim 13, wherein the metal via and the metal line include a same metal.

15. The integrated circuit device of Claim 14, wherein the same metal is ruthenium, Ru.
